# EUROPÄISCHE PATENTSCHRIFT

(11) **EP 4 131 368 B1**
(45) Veröffentlichungstag und Bekanntmachung des Hinweises auf die Patenterteilung: **12.03.2025**
(21) Anmeldenummer: 22186872.2
(22) Anmeldetag: 26.07.2022
(51) Int. Cl.: H01L 23/40, H05K 7/20

(54) **MODULGEHÄUSE AUS KUNSTSTOFF MIT EINGEBETTETEM KÜHLKÖRPER**
PLASTIC MODULE HOUSING WITH EMBEDDED HEAT SINK
BOÎTIER MODULAIRE EN MATIÈRE PLASTIQUE POURVU DE DISSIPATEUR THERMIQUE INCORPORÉ

(30) Priorität: 06.08.2021 DE 102021208578
(43) Veröffentlichungstag der Anmeldung: 08.02.2023
(73) Patentinhaber: ZF Friedrichshafen AG, 88046 Friedrichshafen (DE)
(72) Erfinder: Singer, Michael, 95671 Bärnau (DE); Küpfer, Oliver, 91322 Gräfenberg (DE); Schober, Thomas, 92256 Hahnbach (DE)

(56) Entgegenhaltungen:
- EP-A1- 2 175 708
- EP-B1- 1 006 766
- DE-U1- 202017 104 164

## Beschreibung

Die Erfindung betrifft ein Modulgehäuse aus Kunststoff, insbesondere aus Duroplast, mit einem eingebetteten Kühlkörper, das an einer Wärmesenke montierbar ist.

Elektrische und elektronische Geräte oder Module werden häufig mit einem Gehäuse aus Duroplast versehen. Diese haben ebenso wie Gehäuse aus Thermoplast gegenüber metallischen Gehäusen den Vorteil, dass sie ein nur geringes Gewicht haben, gute elektrische Isolationseigenschaften aufweisen und mit einer sehr hohen Oberflächenqualität in einer hohen Formenvielfalt durch Urformen herstellbar sind.

Das Gehäuse kann als separates Gebilde innenliegende Geräte- bzw. Modulbestandteile einschließen oder aber als Materialmasse die Geräte- bzw. Modulbestandteile, unmittelbar umhüllen. Gehäusebestandteile, wie z. B. Anschraubhülsen, die aus Metall sein müssen oder aber Geräte- bzw. Modulbestandteile, die eine Schnittstelle zur Umgebung aufweisen müssen, wie z. B. ein Kühlkörper, können beim Herstellen des Gehäuses in das Formwerkzeug eingelegt und mit dem Gießen oder Verpressen des Kunststoffes eingegossen bzw. eingepresst werde.

Im Vergleich zu Gehäusen aus Thermoplast sind solche aus Duroplast formbeständiger und wärmefest, was insbesondere für Geräte und Module von Vorteil ist, deren Betrieb mit einer hohen Wärmeentwicklung von statten geht. Für Anwendungen bei denen das Gehäuse mechanischen Belastungen unterliegen kann, hat Duroplast allerdings den Nachteil, dass es spröde und daher leicht zerbrechlich ist.

EP 2 175 708 A1 offenbart ein Elektronikmodul mit einer Wärmesenke. Das Elektronikmodul umfasst ein Gehäuse, welches an eine leitfähige Platte mittels einer Schraubverbindung angeordnet wird.

EP 1 006 766 A1 zeigt eine elektronische Vorrichtung mit einem zweiteiligen Gehäuse zur Aufnahme einer elektronischen Schaltung.

In DE 20 2017 104 164 U1 ist ein Montagesystem und eine Kühlvorrichtung für COM-Module gezeigt.

Es ist aus der Praxis bekannt Gehäuse für Module (nachfolgend Modulgehäuse) insbesondere für elektronische Schaltungsmodule, aus Duroplast auszuführen. Diese Schaltungsmodule enthalten im Wesentlichen eine mit elektronischen Bauelementen bestückte Leiterplatte und einen Kühlkörper, zur Abführung der durch die elektronischen Bauelemente erzeugten Wärme. Um die vom Kühlkörper aufgenommene Wärme durch Wärmeleitung von diesem abzuführen, muss er in einen guten Flächenkontakt mit einer externen Wärmesenke gebracht werden, was die Wirkung einer Andruckkraft und eine nur geringe Ebenheitstoleranz erfordert. Je besser der Flächenkontakt ist, desto schneller wird die Wärme dem Kühlkörper entzogen.

Die Relativlage des Kühlkörpers innerhalb des Modulgehäuses ist bestimmt vom Design des Schaltungsmoduls, bei dem der Kühlkörper zu den Bauelementen in der Regel so angeordnet ist, dass der Kühlkörper stirnseitig des Modulgehäuses entweder unmittelbar oder mittelbar über einen möglichst kurzen Wärmeleiter mit dem Kühlkörper in Verbindung steht. Es ergibt sich daraus, dass der Kühlkörper innerhalb des Modulgehäuses zu dessen Rand hin in verschiedensten Relativlagen angeordnet sein kann. Vom Schaltungsmodul abgewandt, nach außen gerichtet, weist der Kühlkörper eine ringsum eingebettete, freie Planfläche auf, die mit einem als externe Wärmesenke dienenden Träger in Kontakt gebracht wird, indem das Modulgehäuse über zwei, ebenfalls in das Modulgehäuse eingebettete, Anschraubhülsen an dem Träger mittelbar oder unmittelbar verschraubt wird.

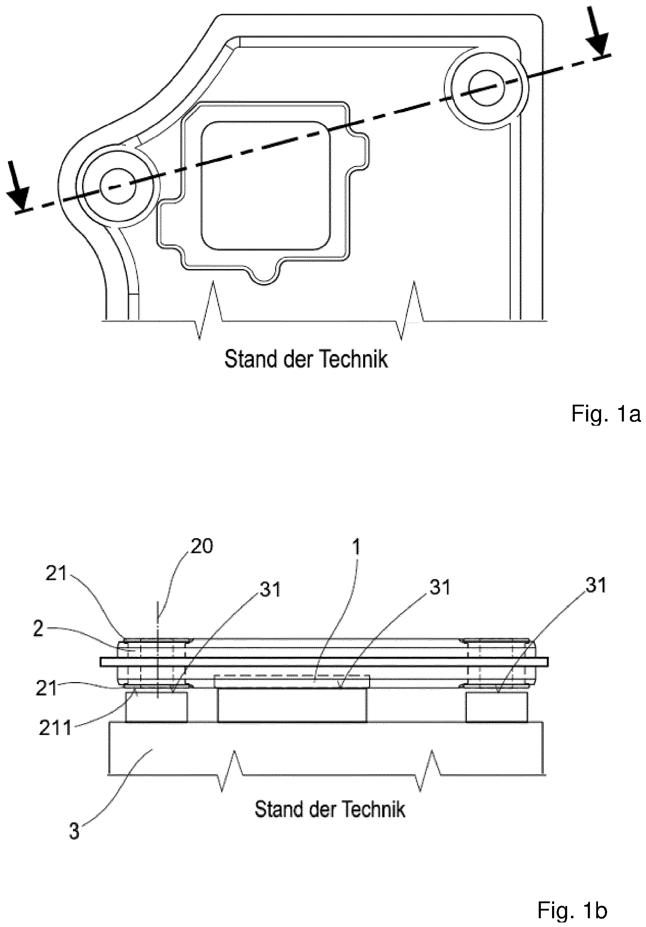

In Fig. 1a und 1b ist ein solches Modulgehäuse, gemäß dem Stand der Technik, dargestellt. Um eine gute kraftschlüssige Verbindung zwischen dem Kühlkörper und der Wärmesenke herzustellen sind die beiden Anschraubhülsen relativ zum Kühlkörper so angeordnet, dass eine zwischen ihnen gedachte Verbindungsgerade über die freie Planfläche des Kühlkörpers verläuft.

Für einen optimalen Wärmeentzug vom Kühlkörper weist die Wärmesenke üblicherweise eine der freien Planfläche des Kühlkörpers in Größe und Form angepasste Anlagefläche auf. Die jeweils mit einem Abstand zum Kühlkörper eingebetteten Anschraubhülsen sind bei bestimmungsgemäßer Anlage des Kühlkörpers an der Wärmesenke gegenüber von Anschraubbuchsen positioniert. Diese können in dem als Wärmesenke dienenden Träger oder in mit dem Träger fest verbundenen Bauteilen angeordnet sein. Damit sich der Kühlkörper bei der Montage mit einer Andruckkraft an den Träger anlegt, sind die Anlageflächen am Träger zum einen für den Kühlkörper und zum anderen für die Anschraubhülsen so in ihrer relativen Höhe zu zueinander dimensioniert bzw. toleriert, dass über das Anziehen der durch die Anschraubhülsen in den Träger geschraubten Schrauben eine Andruckkraft des Kühlkörpers auf den Träger bewirkt wird. Dabei werden Biegespannungen in dem Modulgehäuse entlang der gedachten Verbindungslinie erzeugt, die bei einem spröden Kunststoff zur Rissbildung führen können.

Es ist die Aufgabe der Erfindung ein Modulgehäuse aus Kunststoff mit einem eingebetteten Kühlkörper so zu verbessern, dass es frei von Biegespannungen an einem Träger befestigt werden kann.

Diese Aufgabe wird für ein Modulgehäuse aus Kunststoff, insbesondere aus Duroplast, mit einem eingebetteten Kühlkörper und wenigstens einer eingebetteten Anschraubhülse, die einen Bund mit einer nach außen freiliegenden Anschraubfläche aufweist und zur Montage des Modulgehäuses an einem als externe Wärmesenke dienenden Träger vorgesehen ist, gelöst, indem der Kühlkörper und die wenigstens eine Anschraubhülse, einen monolithischen Körper bildend, miteinander verbunden sind, womit ein Wärmeentzug vom Kühlkörper, durch Wärmeleitung zu dem Träger, wenigstens über die Anschraubfläche erfolgt. Mit dem Anschrauben des Modulgehäuses an den Träger wird über die Anschraubfläche der wenigstens einen Anschraubhülse eine Andruckkraft in den Träger geleitet die eine gleichgroße Gegenkraft bewirkt. Diese Gegenkraft wird von dem durch den Kühlkörper und der wenigstens einen Anschraubhülse gebildeten monolithischen Körper aufgenommen. Da sich der Kühlkörper in Folge der Gegenkraft, die je nach Anlage des monolithischen Körpers am Träger auf diesen verteilt unterschiedlich einwirken kann, höchstens vernachlässigbar biegt, werden auch höchstens vernachlässigbare Biegespannungen in den Kunststoff eingetragen.

Monolithisch bedeutet, dass der Körper aus einer einheitlichen, nicht trennbaren Einheit besteht.

Spannungstechnisch vorteilhaft ist genau eine Anschraubhülse vorhanden, wobei die Anschraubfläche gegenüber dem Kühlkörper erhaben dimensioniert oder toleriert ist. Bei der Montage des Modulgehäuses an den Träger kommt dann nur die Anschraubfläche an den Träger zur Anlage, womit eine Eintragung von Biegespannungen in das Modulgehäuse gänzlich vermieden wird. Außerdem muss zur Minimierung der Ebenheitstoleranz nur die Anschraubfläche einer finalen Oberflächenbearbeitung unterzogen werden. Alternativ kann der Träger so konzipiert sein, dass nur die Anschraubfläche zur Anlage an den Träger kommt, selbst wenn der Kühlkörper gegenüber der Anschraubfläche nicht relativ zurückgesetzt ist. Ein ausschließlicher Wärmeentzug durch Wärmeleitung nur über die Anschraubfläche hat insbesondere den Vorteil, dass zur Minimierung der Ebenheitstoleranz nur die Anschraubfläche einer finalen Oberflächenbearbeitung unterzogen werden muss. Auch wenn zusätzlich zur Anschraubfläche weitere Flächenbereiche des monolithischen Körpers zur Anlage an den Träger gebracht werden, werden quasi keine Biegespannungen in den Kunststoff eingetragen. Um einen optimalen Wärmentzug vom Kühlkörper zur Anschraubhülse zu erreichen ist der Querschnitt einer monolithischen Verbindung in seiner Höhe und/oder Breite an die Höhe des Kühlkörpers und den Außendurchmesser der Anschraubhülse angepasst.

Erfindungsgemäß ist die Anschraubhülse über eine Höhe des Kühlkörpers in Richtung einer Zylin- derachse der Anschraubhülse vollständig mit dem Kühlkörper verbunden, womit ein Querschnitt der monolithischen Verbindung zwischen dem Kühlkörper und der An- schraubhülse in Richtung der Höhe des Kühlkörpers für den Wärmeentzug optimiert ist.

Alternativ oder zusätzlich ist die Anschraubhülse über eine Breite mit dem Kühlkörper verbunden, die mindestens dem Außendurchmesser der Anschraubhülse entspricht, womit ein Querschnitt der monolithischen Verbindung zwischen dem Kühlkörper und der Anschraubhülse in Richtung der Breite des Kühlkörpers für den Wärmeentzug optimiert ist.

Für eine optimale Übertragung der Andruckkraft ist die Anschraubfläche bevorzugt weitestgehend ringförmig ausgeführt.

Für einen optimalen Entzug der Wärme weist die Anschraubfläche bevorzugt einen Außendurchmesser auf, der wenigstens doppelt so groß ist, wie der Innendurchmesser der Anschraubfläche groß ist.

Vorzugsweise kann ein erfindungsgemäßes Modulgehäuse in einer elektrischen Baugruppe verwendet werden. Beispielsweise ist die elektrische Baugruppe ein Inverter und/oder ein Getriebe.

Vorteilhafterweise wird eine elektrische Baugruppe mit einem erfindungsgemäßen Modulgehäuse in einem Kraftfahrzeug, insbesondere einem Elektrofahrzeug verwendet. Die ermöglicht den Einsatz eines erfindungsgemäßen Modulgehäuses in der Automobilindustrie.

Nachfolgend wird die Erfindung an einem Ausführungsbeispiel anhand von Zeichnungen näher erläutert. Hierzu zeigen:
- Fig. 1a und 1b: ein Modulgehäuse gemäß dem Stand der Technik in einer Draufsicht und in einem Schnittbild und
- Fig. 2a bis 2b: ein erfindungsgemäßes Modulgehäuse in einer Draufsicht, in einem Schnittbild und einer perspektivischen Darstellung.

Gleich dem Stand der Technik, dargestellt in den Fig. 1a - 1b, besteht ein erfindungsgemäßes Modulgehäuse aus Kunststoff, bevorzugt aus Duroplast. In ihm sind ein Kühlkörper 1 und wenigstens eine Anschraubhülse 2 eingebettet. Während gemäß dem Stand der Technik ein Wärmeentzug vom Kühlkörper 1 unmittelbar über eine freie Grundfläche des Kühlkörpers erfolgt (thermische Schnittstelle) und die wenigstens eine Anschraubhülse 2 nur die Funktion einer mechanischen Schnittstelle aufweist, stellt die wenigstens eine Anschraubhülse 2 eines erfindungsgemäßen Modulgehäuses sowohl eine mechanische als auch eine thermische Schnittstelle dar. Dazu ist die wenigstens eine Anschraubhülse 2, einen monolithischen Körper 0 bildend, mit dem Kühlkörper 1 verbunden.

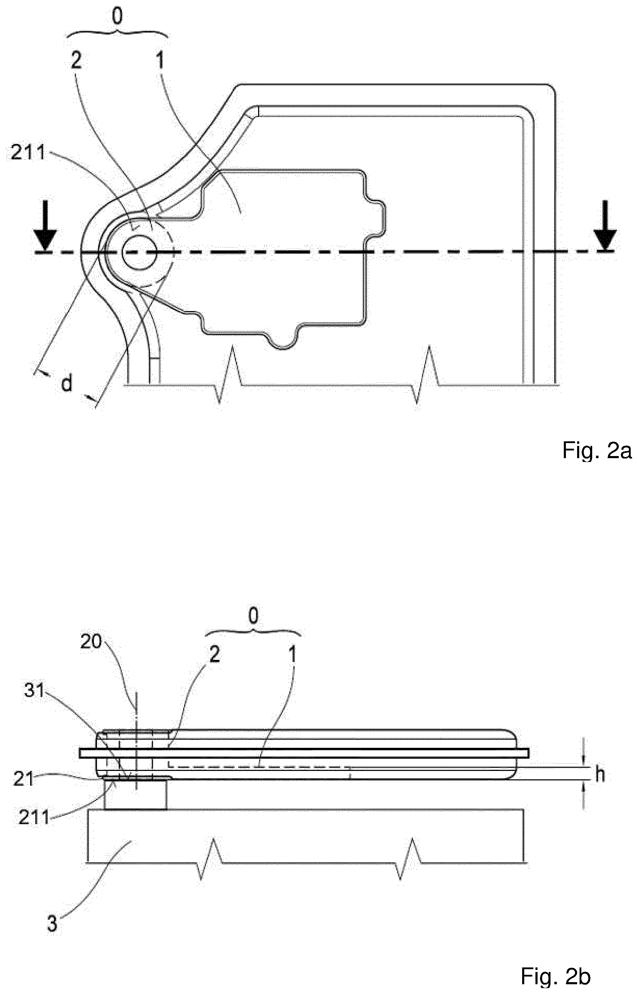

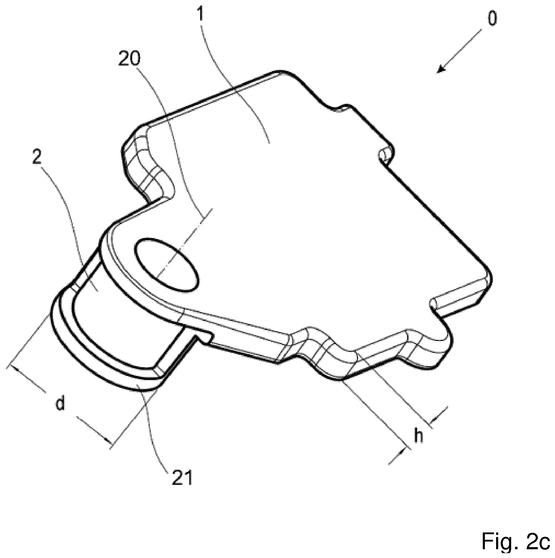

Gemäß dem in den Fig. 2a - 2c gezeigten Ausführungsbeispiel, weist der monolithische Körpers genau eine Anschraubhülse 2 auf, mit einem Bund 21 mit einer nach außen freiliegenden Anschraubfläche 211, die bei der Montage des Modulgehäuses an einem als externe Wärmesenke dienenden Träger 3 zur Anlage kommt. Im gezeigten Ausführungsbeispiel ist die Anschraubfläche 211 integraler Bestandteil einer planen Grundfläche, die sich über den gesamten monolithischen Körper 0 erstreckt.

Wird das Modulgehäuse, wie gezeigt, an einem Träger 3 montiert, der dem Modulgehäuse eine Anlagefläche 31 zuwendet, die auf die Maße der Anschraubfläche begrenzt sind, erfolgt der Wärmeentzug durch Wärmeleitung, aber auch der Krafteintrag ausschließlich über die Anschraubfläche 211. vorteilhaft ist hier nur die Anschraubfläche hoch eben final gefertigt. Ist die Anlagefläche 31 am Träger 3 größer dimensioniert, bis hin zu einer Größe gleich der Grundfläche des monolithischen Körpers 0 (nicht in den Zeichnungen dargestellt), erfolgt über die gesamte Bodenfläche der Wärmeentzug durch Wärmeleitung, was allerdings hohe Ansprüche an die Ebenheit der Grundfläche und der Anlagefläche 31 stellt. Um die gesamte Bodenfläche gleichmäßig an eine Anlagefläche 31 am Träger 3 anzudrücken, können eine oder auch zwei weitere, im monolithischen Körper ausgebildete Anschraubhülsen 2 vorhanden sein.

### Bezugszeichen

- 0: monolithischer Körper
- 1: Kühlkörper
- 2: Anschraubhülse
- 20: Zylinderachse
- 21: Bund
- 211: Anschraubfläche
- 22: Zylinderachse
- 3: Träger
- 31: Anlagefläche
- h: Höhe des Kühlkörpers
- d: Außendurchmesser der Anschraubhülse

## Patentansprüche

1. Modulgehäuse aus Kunststoff mit einem eingebetteten Kühlkörper (1) und wenigstens einer eingebetteten Anschraubhülse (2), die einen Bund (21) mit einer nach außen freiliegenden Anschraubfläche (211) aufweist und zur Montage des Modulge- häuses an einem als externe Wärmesenke dienenden Träger (3) vorgesehen ist, wobei der Kühlkörper (1) und die wenigstens eine Anschraubhülse (2) einen monolithischen Körper (0) bilden, womit ein Wärmeentzug vom Kühlkörper (1) durch Wärmeleitung zu dem Träger (3) wenigstens über die Anschraubfläche erfolgt, wobei genau eine Anschraubhülse (2) vorhanden ist und die Anschraubfläche (211) gegenüber dem Kühlkörper (1) erhaben ist, so dass bei der Montage des Modulgehäuses nur die Anschraubfläche (211) an dem Träger (3) zur Anlage kommt, **dadurch gekennzeichnet, dass** die Anschraubhülse (2) über die Höhe des Kühlkörpers (h) in Richtung einer Zylinderachse (20) der Anschraubhülse vollständig mit dem Kühlkörper (1) verbunden ist, womit ein Querschnitt der monolithischen Verbindung zwischen dem Kühlkörper (1) und der Anschraubhülse (2) in Richtung der Höhe des Kühlkörpers (h) für den Wärmeentzug optimiert ist.

2. Modulgehäuse aus Kunststoff mit einem eingebetteten Kühlkörper, nach dem vorherigen Anspruch, **dadurch gekennzeichnet, dass** die Anschraubhülse über eine Breite mit dem Kühlkörper (1) verbunden ist, die mindestens einem Außendurchmesser der Anschraubhülse (d) entspricht, womit ein Querschnitt der monolithischen Verbindung zwischen dem Kühlkörper (1) und der Anschraubhülse (2) in Richtung der Breite des Kühlkörpers (1) für den Wärmeentzug optimiert ist.

3. Modulgehäuse aus Kunststoff mit einem eingebetteten Kühlkörper, nach einem der vorherigen Ansprüche, **dadurch gekennzeichnet, dass** die Anschraubfläche (211) ringförmig ist.

4. Modulgehäuse aus Kunststoff mit einem eingebetteten Kühlkörper, nach Anspruch 3, **dadurch gekennzeichnet, dass** die Anschraubfläche (211) einen Außen- durchmesser aufweist, der wenigstens doppelt so groß ist, wie der Innendurchmesser der Anschraubfläche (211).

5. Modulgehäuse aus Kunststoff mit einem eingebetteten Kühlkörper, nach einem der vorgenannten Ansprüche, **dadurch gekennzeichnet, dass** der Kunststoff Duroplast ist.

6. Elektrische Baugruppe umfassend ein Modulgehäuse nach einem der vorherigen Ansprüche.

7. Kraftfahrzeug mit einer Steuerung umfassend eine elektrische Baugruppe nach dem Anspruch 6.

## Claims

1. Module housing made of plastic, with an embedded cooling element (1) and at least one embedded screw-on sleeve (2), which has a collar (21) with an outwardly exposed screw-on surface (211) and is intended for mounting the module housing on a support (3) serving as an external heat sink, wherein the cooling element (1) and the at least one screw-on sleeve (2) form a monolithic element (0), whereby heat is extracted from the cooling element (1) to the support (3) by heat conduction at least via the screw-on surface, wherein there is precisely one screw-on sleeve (2), and the screw-on surface (211) is raised in relation to the cooling element (1) such that, when the module housing is mounted, only the screw-on surface (211) comes to bear against the support (3), **characterized in that** the screw-on sleeve (2) is completely connected to the cooling element (1) over the height of the cooling element (h) in the direction of a cylindrical axis (20) of the screw-on sleeve, whereby a cross section of the monolithic connection between the cooling element (1) and the screw-on sleeve (2) in the direction of the height of the cooling element (h) is optimized for the heat extraction.

2. Module housing made of plastic, with an embedded cooling element, according to the preceding claim, **characterized in that** the screw-on sleeve is connected to the cooling element (1) over a width which corresponds at least to an outer diameter of the screw-on sleeve (d), whereby a cross section of the monolithic connection between the cooling element (1) and the screw-on sleeve (2) in the direction of the width of the cooling element (1) is optimized for the heat extraction.

3. Module housing made of plastic, with an embedded cooling element, according to one of the preceding claims, **characterized in that** the screw-on surface (211) is annular.

4. Module housing made of plastic, with an embedded cooling element, according to Claim 3, **characterized in that** the screw-on surface (211) has an outer diameter which is at least twice the size of the inner diameter of the screw-on surface (211).

5. Module housing made of plastic, with an embedded cooling element, according to one of the preceding claims, **characterized in that** the plastic is a thermosetting polymer.

6. Electrical assembly comprising a module housing according to one of the preceding claims.

7. Motor vehicle with a control comprising an electrical assembly according to Claim 6.

## Revendications

1. Boîtier de module en matière plastique pourvu d'un dissipateur thermique (1) incorporé et au moins une douille à visser (2) incorporée, qui possède un collet (21) avec une surface de vissage (211) exposée vers l'extérieur et qui est prévue pour le montage du boîtier de module sur un élément porteur (3) servant de puits thermique externe, le dissipateur thermique (1) et l'au moins une douille à visser (2) formant un corps monolithique (0), ce par quoi il se produit une extraction de chaleur du dissipateur thermique (1) par conduction thermique vers l'élément porteur (3) au moins par le biais de la surface de vissage, exactement une douille à visser (2) étant présente et la surface de vissage (211) étant en relief par rapport au dissipateur thermique (1), de sorte que lors du montage du boîtier de module, seule la surface de vissage (211) vient en appui contre l'élément porteur (3), **caractérisé, en ce que** la douille à visser (2) est entièrement reliée au dissipateur thermique (1) sur la hauteur du dissipateur thermique (h) dans la direction d'un axe de cylindre (20) de la douille à visser, ce par quoi une section transversale de la liaison monolithique entre le dissipateur thermique (1) et la douille à visser (2) dans le sens de la hauteur du dissipateur thermique (h) est optimisée pour l'extraction de chaleur.

2. Boîtier de module en matière plastique pourvu d'un dissipateur thermique incorporé selon la revendication précédente, **caractérisé en ce que** la douille à visser est reliée au dissipateur thermique (1) sur une largeur qui correspond au moins à un diamètre extérieur de la douille à visser (d), ce par quoi une section transversale de la liaison monolithique entre le dissipateur thermique (1) et la douille à visser (2) dans le sens de la largeur du dissipateur thermique (1) est optimisée pour l'extraction de chaleur.

3. Boîtier de module en matière plastique pourvu d'un dissipateur thermique incorporé selon l'une des revendications précédentes, **caractérisé en ce que** la surface de vissage (211) est de forme annulaire.

4. Boîtier de module en matière plastique pourvu d'un dissipateur de chaleur encastré selon la revendication 3, **caractérisé en ce que** la surface de vissage (211) présente un diamètre extérieur qui est au moins deux fois plus grand que le diamètre intérieur de la surface de vissage (211).

5. Boîtier de module en matière plastique pourvu d'un dissipateur thermique incorporé selon l'une des revendications précédentes, **caractérisé en ce que** la matière plastique est un plastique thermodurcissable.

6. Sous-ensemble électrique comprenant un boîtier de module selon l'une des revendications précédentes.

7. Véhicule automobile équipé d'une commande comprenant un sous-ensemble électrique selon la revendication 6.
